# EUROPÄISCHE PATENTSCHRIFT

(11) **EP 1 271 399 B1**
(45) Veröffentlichungstag und Bekanntmachung des Hinweises auf die Patenterteilung: **26.08.2009**
(21) Anmeldenummer: 02021127.2
(22) Anmeldetag: 10.05.1995
(51) Int. Cl.: G06K 19/077

(54) **Datenträger mit integriertem Schaltkreis**
Data carrier with integrated circuit
Porteur de données avec circuit intégré

(30) Priorität: 11.05.1994 DE 4416697
(43) Veröffentlichungstag der Anmeldung: 02.01.2003
(62) Teilanmeldung aus: 95107090.3
(73) Patentinhaber: Giesecke & Devrient GmbH, 81677 München (DE)
(72) Erfinder: Haghiri-Tehrani, Yahya, 80797 München (DE)
(74) Vertreter: Klunker . Schmitt-Nilson . Hirsch

(56) Entgegenhaltungen:
- EP-A- 0 570 062
- WO-A-88/08592
- DE-A- 4 105 869

## Beschreibung

Die Erfindung betrifft einen Datenträger gemäß dem Oberbegriff des Anspruchs 1. Ferner betrifft die Erfindung ein Verfahren zur Herstellung eines Datenträgers.

Datenträger mit integrierten Schaltkreisen werden in Form von Kreditkarten, Bankkarten, Barzahlungskarten und dergleichen in den verschiedensten Dienstleistungssektoren, beispielsweise im bargeldlosen Zahlungsverkehr oder im innerbetrieblichen Bereich, als Zugangsberechtigung eingesetzt. Bei einem Großteil dieser Datenträger erfolgt die Energieversorgung und/oder der Datenaustausch mit externen Geräten berührend über die äußeren Kontaktflächen eines elektronischen Moduls. Da bei diesen Datenträgern nach dem Stand der Technik die Kontaktflächen zum Anschluß der Datenträger an eine Lese-/Schreibeinrichtung freiliegen, besteht die Gefahr einer Verschmutzung der Kontaktflächen, wodurch in Folge einer schlechten Kontaktierung eine fehlerhafte Datenübertragung zwischen dem Datenträger und der betreffenden Lese-/Schreibeinrichtung des Terminals auftreten kann. Unabhängig davon kann eine fehlerhafte Datenübertragung auch aufgrund einer fehlerhaften Positionierung der Kontaktflächen in der Lese-/Schreibeinrichtung des Terminals auftreten. Zur Vermeidung der o.g. Nachteile sind aus dem Stand der Technik bereits Datenträger mit kontaktloser, z. B. induktiver Kopplung, bekannt.

Aus der EP-A1 0 376 062 ist z. B. ein elektronisches Modul und ein Verfahren zur Herstellung des Moduls bekannt. Das bekannte Modul beinhaltet einen isolierenden Trägerfilm, einen Chip mit integriertem Schaltkreis, der wenigstens zwei Verbindungsanschlüsse aufweist und auf dem Trägerfilm angeordnet ist. Auf der gleichen Seite des Trägerfilms des Moduls ist eine Spule angeordnet. Die Spule, welche Bestandteil des Moduls ist, ermöglicht hierbei die induktive Kopplung zwischen dem Modul und einem externen Gerät. Die Spule ist als ringförmige, drahtgewickelte Spule ausgeführt, die einen Raum umgibt, in dem der Chip und die die Anschlüsse des Chips mit den Anschlüssen der Spule elektrisch leitend verbindenden Elemente komplett untergebracht sind und der anschließend mit einer elektrisch isolierenden und gehärteten klebenden Masse gefüllt ist. Das bekannte Modul wird nach seiner Fertigstellung dann in eine Karte eingebaut, wobei die Spule einen wirksamen Schutz des Chips und der elektrisch leitenden Verbindungselemente gegen Spannungen, denen diese Karte beim Gebrauch ausgesetzt ist, gewährleistet.

Durch die Anordnung der Spule auf dem Modul ist zwar einerseits ein guter Schutz für den Chip erreicht, andererseits bringt es dieser spezielle Aufbau eines Moduls mit sich, daß zur Herstellung eines Datenträgers mit kontaktloser Kopplung speziell aufgebaute Module verwendet werden müssen. Dies hat den Nachteil, daß zur Fertigung der Module ein spezielles Verfahren benötigt wird bzw. spezielle Werkzeuge bereitgestellt werden müssen. Darüber hinaus können bedingt durch die spezielle Fertigung dieser Module herkömmliche, d. h. Module ohne Spule für die Herstellung eines Datenträgers mit kontaktloser Kopplung nicht verwendet werden. Schließlich können bei kleinen Auflagen von Datenträgern mit kontaktloser Kopplung mit einem speziell hergestellten Modul hohe Kosten entstehen, da dieses gesondert gefertigt werden muß. Dies alles bedeutet, daß durch diese speziellen Module die Flexibilität bei der Herstellung von Datenträgern mit kontaktloser Kopplung beeinträchtigt ist.

Der Erfindung liegt somit die Aufgabe zugrunde, einen Datenträger mit kontaktloser Kopplung vorzuschlagen, der einfacher herstellbar ist.

Aus der DE 51 05 869 A1 ist eine EC Karte bekannt, in deren Inneren ein Streifen einer Trägerfolie eingelagert ist, auf der zwei Flachspulen und ein Chip angeordnet sind. Die Terminals des Chips sind mittels Bond-Drähtchen mit den Kontaktflächen verbunden, die auf der anderen Seite der Trägerfolie angeordnet sind. Diese Trägerfolie mit Spulen und Chip muss separat und speziell gefertigt werden. Es ist nicht möglich die Trägerfolie für andere als die beschriebenen Karten zu verwenden.

Aus der WO 88/08592 A ist ein mehrschichtiger Datenträger mit einer Schicht bekannt, auf die eine Flachspule aufgebracht ist. Die Schicht weist eine Ausnehmung auf, in die ein integrierter Schaltkreis, also kein Modul eingesetzt ist. Der integrierte Schaltkreis wird mit sogenannten Bond-Drähtchen mit der Spule verbunden. Diese elektrische Verbindung kann dann mit einem isolierendem Epoxiharz vergossen werden. Die unabhängigen Ansprüche sind gegen dieses Dokument abgegrenzt.

Die Aufgabe wird durch die in den unabhängigen Ansprüchen angegebenen Merkmale gelöst.

Der Grundgedanke der Erfindung besteht in der Entkopplung von Modul und Spule, wobei das Modul in an sich bekannter Weise separat hergestellt werden kann und die Spule unabhängig von dem Modul gefertigt und auf einer Schicht des Kartenkörpers aufgebracht wird.

Die Spule kann beispielsweise auf einer Deckschicht oder auf einer inneren Schicht eines mehrschichtig aufgebauten Kartenkörpers oder auf einem spritzgegossenen Kartenkörperteil angeordnet werden. Die Spule kann z. B. drahtgewickelt oder auch als elektrisch leitende Schicht im Siebdruckverfahren z. B. mittels eines elektrisch leitenden Klebers auf die Kartenkörperschicht aufgedruckt werden. Die Spule kann auch alternativ aus einer Metallfolie gestanzt oder aus einer elektrisch leitend beschichteten Kunststoffolie geätzt und auf die Kartenkörperschicht aufgeklebt werden. Weiter ist es auch möglich, daß die Spule in Form einer elektrisch leitenden Schicht im Heißprägeverfahren in die Kartenkörperschicht geprägt wird. Vorzugsweise ist die Spule als Flachspule ausgebildet, wobei die Anschlüsse der Spule und die Kontaktelemente des Moduls bezüglich der Lage und Position im Kartenkörper in bezug aufeinander normiert sind, und einander direkt gegenüber angeordnet sind, wodurch eine einfache elektrisch leitende Verbindung zwischen den Anschlüssen der Spule und denen des Moduls hergestellt werden kann. Dies kann beispielsweise mit Hilfe eines elektrisch leitenden Klebers oder auch mittels Löten oder anderer gängiger Techniken, die dem Fachmann bekannt sind, erfolgen. Das Modul ist als Hybridmodul ausgeführt das zusätzlich äußere Kontaktflächen zur berührenden Kopplung mit externen Geräten aufweist.

Die mit der Erfindung erzielten Vorteile bestehen insbesondere darin, daß die in herkömmlicher Weise hergestellten Module, d. h. Module ohne Spulen, verwendbar sind, wodurch die Herstellung von Datenträgern mit kontaktloser Kopplung flexibler gestaltet werden kann. Dadurch ist keine nennenswerte Änderung bei der bisherigen Modulherstellung notwendig, so daß keine speziellen neuen Werkzeuge und auch kein neues Verfahren zur Herstellung der Module benötigt wird. Darüber hinaus ermöglicht die Erfindung aufgrund der Anordnung der Spule auf einer Kartenkörperschicht auch eine hohe Flexibilität bei der Auslegung der. Spule, beispielsweise hinsichtlich der benötigten Induktivität, z. B. bei der Windungszahl, bei der aktiven Spulenfläche bzw. dem Drahtdurchmesser etc. und auch eine hohe Flexibilität bei der Auswahl der Technik, in der die Spule auf der Kartenkörperschicht realisiert wird. Darüber hinaus ermöglicht die Erfindung eine einfache Verbindung des Moduls mit der Spule, insbesondere dann, wenn die Spulenanschlüsse und die Kontaktelemente des Moduls, die mit den Spulenanschlüssen elektrisch verbunden werden, hinsichtlich der Lage und Position im Kartenkörper standardisiert sind. Auch kann der Aufbau des Moduls bis auf die Lage und Position der Kontaktelemente frei gewählt werden, so können beispielsweise die Kontaktelemente des Moduls aus einem elektrisch leitend beschichteten Trägerfilm oder in der Leadframe-Technik aus einem Metallband durch entsprechendes Stanzen erhalten werden. Der integrierte Schaltkreis kann hierbei z. B. mit Hilfe eines Klebers auf einem zentralen Bereich des gestanzten Leiterrahmens aufgeklebt werden. Die elektrisch leitende Verbindung des integrierten Schaltkreises mit den Kontaktelementen des Moduls kann z. B. in bekannter Weise per wire-bondingoder in der sogenannten TAB-Technik erfolgen. Diese Techniken und die in diesem Zusammenhang unterschiedlichen Ausgestaltungen der Module sind dem Fachmann geläufig.

Weitere Eigenschaften und Vorteile der Erfindung ergeben sich aus der nachfolgenden Beschreibung verschiedener Beispiele, die anhand der Zeichnungen näher erläutert sind.

Ausführungsformen und Hintergrundinformationen zur Erfindung ergeben sich aus den Zeichnungen. Darin zeigen:
- Fig. 1: einen Datenträger in der Aufsicht, wobei das Modul und ein Teil der Spule als Ausschnitt ohne obere Deckschicht dargestellt sind,
- Fig. 2: den Ausschnitt des Datenträgers gemäß Fig. 1 in einer Schnittdarstellung,
- Fig. 3: die Aufsicht auf einen Datenträger, wobei das Modul und ein Teil der Spule als Ausschnitt dargestellt sind,
- Fig. 4: den Ausschnitt des Datenträgers gemäß Fig. 3 in einer Schnittdarstellung,
- Fig. 5: eine weitere Darstellung mit spritzgegossenem Kartenkörperteil,
- Fig. 6: eine Spritzgußform mit eingelegtem Karteninlett,
- Fig. 7: ein kontaktloses Modul und einen Kartenkörperteil mit Spule,
- Fig. 8: ein Hybridmodul mit zugehörigem Kartenkörperteil und Spule gemäß der Erfindung.

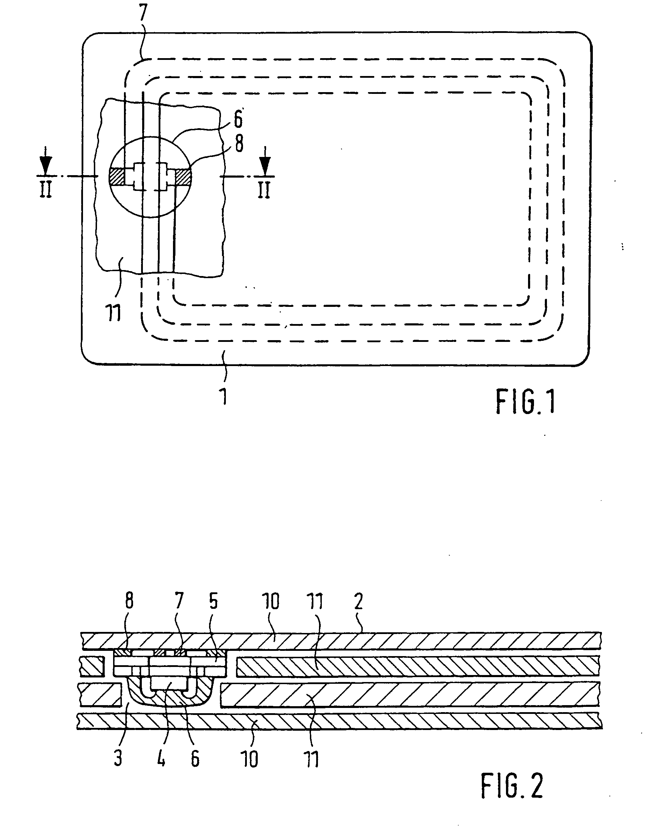

Im folgenden werden als Hintergrundinformation die Figuren 1 bis 7 beschrieben.

Fig. 1 zeigt einen Datenträger 1 umfassend einen Kartenkörper 2 mit einer darauf angeordneten Spule 7, die elektrisch leitend mit einem Modul 6 verbunden ist.

Fig. 2 zeigt vergrößert und nicht maßstabsgetreu einen Querschnitt entlang der in Fig. 1 strichliert eingezeichneten Linie innerhalb des Ausschnitts, der das Modul, einen Teil des Kartenkörpers und der Spule umfaßt. Das Modul 6 umfaßt wenigstens einen integrierten Schaltkreis 4 mit zwei Anschlüssen, die elektrisch leitend mit den Kontaktelementen 5 des Moduls verbunden sind. Das in Fig. 2 gezeigte Modul besteht z. B. aus einem Trägerfilm aus Kapton, der auf einer Seite die Kontaktelemente 5 aufweist. Der Trägerfilm weist in bekannter Weise entsprechend positionierte Fenster zur Aufnahme des integrierten Schaltkreises und zur Hindurchführung der Leiterdrähte vom Schaltkreis zu den Kontaktelementen auf. Zum Schutz vor mechanischen Belastungen können der integrierte Schaltkreis und die Leiterdrähte mit einer Gußmasse vergossen werden. Bei dem hier gezeigten Beispiel eines Moduls sind die Kontaktelemente als elektrisch leitende Beschichtung auf dem Trägerfilm aufgebracht, die dann z. B. per wire-bonding mit den Anschlüssen des integrierten Schaltkreises verbunden werden.

Der in Fig. 2 gezeigte Datenträger wird z. B. in der dem Fachmann geläufigen Laminiertechnik hergestellt, wobei das zuvor separat hergestellte Modul ohne Spule in einen mehrschichtig aufgebauten Kartenkörper einlaminiert wird. Der mehrschichtige Kartenkörper 2 umfaßt jeweils eine obere und untere Deckschicht 10 sowie wenigstens eine innere Kartenschicht 11, die zur Aufnahme des Moduls eine entsprechende Öffnung 3 aufweist. Die Außenflächen der Deckschichten 10 sind in der Regel mit einem Aufdruck versehen. Auf einer der Innenflächen der Deckschichten 10, in diesem Beispiel der oberen Deckschicht, ist eine Spule 7 angeordnet, die mit der Kartenkörperschicht 10 ein Halbzeug bildet. Die Spulenanschlüsse 8 sind derart positioniert, daß sie den Kontaktelementen 5 des Moduls 6 direkt gegenüber angeordnet sind. Dies erlaubt eine einfache elektrisch leitende Verbindung der Kontaktelemente mit den Spulenanschlüssen. Die elektrisch leitende Verbindung kann z. B. mit Hilfe eines elektrisch leitenden Klebers erzielt werden. Die Spule 7 kann z. B. auf eine Kartenkörperschicht im Siebdruckverfahren mittels eines elektrisch leitenden Klebers aufgedruckt werden oder in Form einer elektrisch leitenden Beschichtung im Heißprägeverfahren auf die Kartenkörperschicht aufgebracht werden. Alternativ hierzu kann die Spule 7 auch aus einer Metallfolie oder einer elektrisch leitend beschichteten Kunststoffolie ausgestanzt und auf einer Schicht des Kartenkörpers angeordnet werden. Die Spule kann auch als drahtgewikkelte fertige Spule ohne Kern, z. B. mit Hilfe eines Klebers, auf der Kartenkörperschicht befestigt werden.

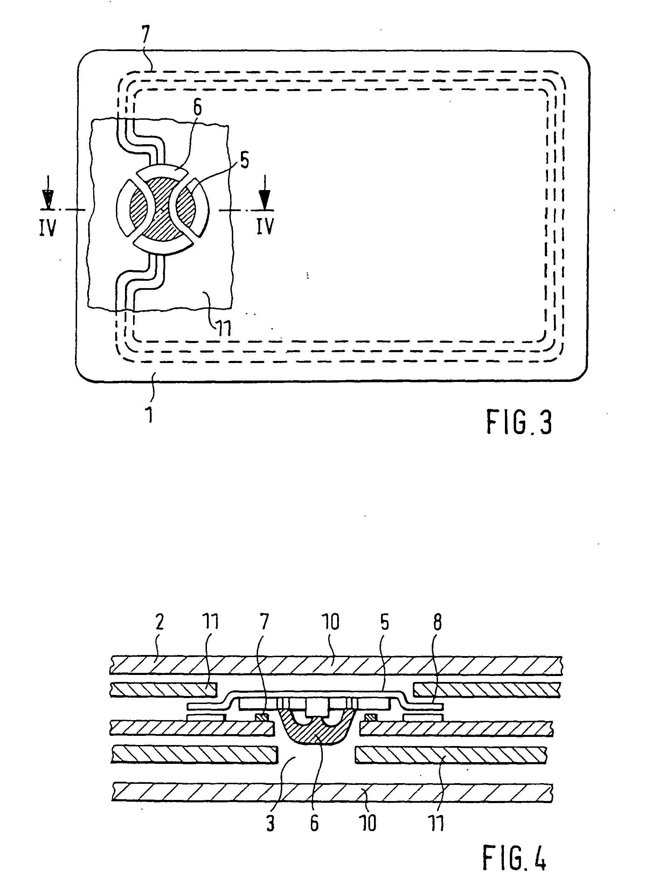

Fig. 3 und 4 zeigen ein weiteres Beispiel eines Datenträgers 1. Dieser unterscheidet sich von dem in Fig. 2 gezeigten im wesentlichen nur dadurch, daß die Spule 7 auf einer inneren Schicht 11 des Kartenkörpers 2 angeordnet ist. Diese innere Schicht des Kartenkörpers weist ebenfalls eine entsprechende Öffnung 3 zur Aufnahme des Moduls 6 auf. Die Kontaktelemente 5 des Moduls sind bei diesem Beispiel vorzugsweise gekröpft, dies erlaubt eine einfache Realisierung der elektrisch leitenden Verbindung mit den Anschlüssen 8 der Spule. Dieses Beispiel hat den Vorteil, daß die inneren Schichten 11, die das Karteninlett des Datenträgers bilden, unabhängig vom Druckvorgang der Deckschichten 10 des Datenträgers zur Montage von Spule und Modul vorbereitet werden können. In den bisher beschriebenen Beispielen wurde der Datenträger vorzugsweise in der Laminiertechnik hergestellt. Selbstverständlich können auch andere Techniken, wie beispielsweise die Spritzgußtechnik oder die Montagetechnik, zum Einsatz kommen. Diese Techniken sind dem Fachmann geläufig und werden daher in den nachfolgenden Beispielen nur kurz erläutert.

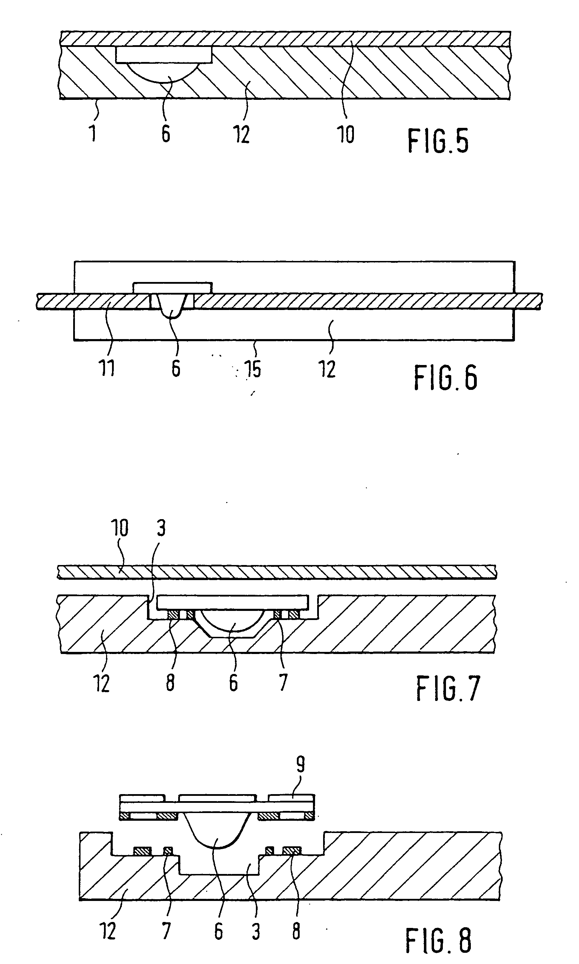

Fig. 5 zeigt stark schematisiert das bereits in Fig. 2 im Querschnitt dargestellte Halbzeug, welches die Kartenkörperschicht 10 mit darauf angeordneter Spule 7 umfaßt, deren Anschlüsse elektrisch leitend mit den Kontaktelementen des Moduls 6 elektrisch leitend verbunden sind. Dieses Halbzeug kann z. B. auch auf einen spritzgegossenen Kartenkörperteil 12, der mit einer entsprechenden Aussparung zur Aufnahme des Moduls versehen ist, montiert und mit dem Kartenkörperteil in bekannter Weise verbunden werden.

Fig. 6 zeigt stark schematisiert das bereits in Fig. 4 dargestellte Karteninlett 11 mit einem Modul 6 und einer Spule 7. Dieses separat hergestellte Halbzeug kann z. B. auch in der Spitzgußtechnik weiterverarbeitet werden. Dazu wird das Karteninlett mit Modul und Spule in bekannter Weise in eine Spritzgußform 15 eingeführt und mit einem Kunststoffmaterial umspritzt, das dann den Kartenkörperteil 12 bildet.

Fig. 7 zeigt schematisiert ein spritzgegossenes Kartenkörperteil 12 mit einer zweistufigen Aussparung 3, wobei auf den Schulterbereichen der Aussparung die Anschlüsse 8 der Spule 7 frei zugänglich angeordnet sind. Dadurch kann das Modul 6 beispielsweise in der bekannten Montagetechnik in einfacher Weise in die Aussparung 3 des Kartenkörperteils 12 eingebaut werden, wobei die elektrisch leitende Verbindung der Spulenanschlüsse mit den Kontaktelementen des Moduls einfach realisierbar ist. Anschließend kann beispielsweise mit Hilfe einer Klebeschicht eine bedruckte Deckschicht 10 mit dem spritzgegossenen Kartenkörperteil 12 verbunden werden.

Fig. 8 zeigt ein Ausführungsbeispiel der Erfindung mit einem Hybridmodul 6, welches zusätzlich zu der Spule 7 äußere Kontaktflächen 9 aufweist, die der berührenden Energieversorgung und/oder dem Datenaustausch dienen. Das Hybridmodul 6 kann ebenfalls in einfacher Weise in der bekannten Montagetechnik in eine dafür vorgesehene Aussparung 3 des spritzgegossenen Kartenkörperteils 12 eingebaut werden. Zur Modulmontage kann beispielsweise eine Haftklebeschicht oder eine thermoaktivierbare Klebeschicht verwendet werden. Das in Fig. 7 gezeigte Aufbringen einer bedruckten Deckschicht kann hier entfallen, da das gewünschte Druckbild bereits beim Spritzgießen des Kartenkörpers mitberücksichtigt wird. In diesem Fall besteht der Kartenkörper dann nur noch aus einer Schicht.

Das Kartenkörperteil aus Figur 8 kann auch gemäß den Beispielen aus den Figuren 1 bis 7 hergestellt sein.

## Patentansprüche

1. Datenträger (I), mit einem kartenförmigen Körper (2), bestehend aus einer oder mehreren Schichten, einem integrierten Schaltkreis (4) sowie wenigstens einer Spule (7), die der Energieversorgung und/oder dem Datenaustausch des integrierten Schaltkreises (4) mit externen Geräten dient,
wobei
ein Modul (6), welches den integrierten Schaltkreis (4) und wenigstens zwei Kontaktelemente (5) aufweist, über die genannten Kontaktelemente mit den Anschlüssen (8) der separat auf einer Schicht des Kartenkörpers (2) angeordneten Spule (7) elektrisch leitend verbunden ist, wobei
die Anschlüsse (8) der Spule (7) derart positioniert sind, dass sie den Kontaktelementen (5) des Moduls (6) direkt gegenüber angeordnet sind, **dadurch gekennzeichnet, dass**
das Modul (6) zusätzlich äußere Kontaktflachen (9) zur berührenden Energieversorgung und/oder zum Datenaustausch mit externen Geräten aufweist.

2. Datenträger nach Anspruch 1, **dadurch gekennzeichnet, dass** die Spule (7) auf einer Deckschicht (10) oder auf einer inneren Schicht (1 1) des Kartenkörpers (2) oder auf einem spritzgegossenen Kartenkörperteil (12) angeordnet ist.

3. Datenträger nach Anspruch 2, **dadurch gekennzeichnet, dass** die Spule (7) als Flachspule ausgebildet ist, die als fertige drahtgewickelte Spule auf einer isolierenden Schicht des Kartenkörpers aufgeklebt oder als elektrisch leitende Schicht auf einer isolierenden Schicht des Kartenkörpers aufgedruckt oder im Heißprägeverfahren in die Kartenkörperschicht geprägt ist oder aus einer Metallfolie oder einer elektrisch leitend beschichteten Kunststofffolie gestanzt und auf einer Schicht des Kartenkörpers angeordnet ist.

4. Datenträger nach Anspruch 2, **dadurch gekennzeichnet, dass** die Spule (7) sich im wesentlichen über die gesamte Fläche des Kartenkörpers (2) erstreckt.

5. Datenträger nach Anspruch 1, **dadurch gekennzeichnet, dass** die AnSchlüsse (8) der Spule (7) elektrisch leitend mit den Kontaktelementen (5) des Moduls (6) verklebt sind.

6. Verfahren zur Herstellung eines Datenträgers (1) mit einem ein- oder mehrschichtigen Kartenkörper (2) einem integrierten Schaltkreis (4) sowie wenigstens einer Spule (7) die der Energieversorgung und/oder dem Datenaustausch des integrierten Schaltkreises (4) mit externen Geräten dient, wobei ein Modul (6) hergestellt wird, das den integrierten Schaltkreis (4) und wenigstens zwei Kontaktelemente (5) aufweist und dass separat von der Herstellung des Moduls (6) auf einer Schicht des Kartenkörpers (2) die Spule (7) aufgebracht wird und dass die genannten Kontaktelemente (5) des Moduls (6) derart positioniert werden, dass sie den Anschlüssen (8) der Spule (7) direkt gegenüber angeordnet werden, **dadurch gekennzeichnet, dass** das Modul (6) zusätzlich äußere Kontaktflächen (9), zur berührenden Energieversorgung und/oder zum Datenaustausch mit zum Datenträger externen Geräten aufweist.

7. Verfahren nach Anspruch 6, **dadurch gekennzeichnet, dass** die Spule auf eine Kartenkörperschicht im Siebdruckverfahren mittels eines elektrisch leitenden Klebers aufgedruckt oder die Spule aus einer Metallfolie oder einer elektrisch leitend beschichteten Kunststofffolie ausgestanzt und auf die Kartenkörperschicht aufgeklebt wird oder die Spule als elektrisch leitende Schicht im Heißprägeverfahren in die Kartenkörperschicht geprägt wird oder als drahtgewickelte Spule auf die Kartenkörperschicht aufgebracht wird.

8. Verfahren nach Anspruch 6, **dadurch gekennzeichnet, dass** die Anschlüsse der Spule mit den Kontaktelementen des Moduls elektrisch leitend verklebt werden.

## Claims

1. A data carrier (1) having a card-shaped body (2) comprising one or more layers, an integrated circuit (4), and at least one coil (7) to be used for power supply and/or for data exchange of the integrated circuit (4) with external devices, wherein
a module (6) having the integrated circuit (4) and at least two contact elements (5) is electroconductively connected via said contact elements to the terminals (8) of the coil (7) disposed separately on a layer of the card body (2), wherein
the terminals (8) of the coil (7) are positioned such that they are disposed directly opposite the contact elements (5) of the module (6),
**characterized in that** the module (6) additionally has outer contact surfaces (9) for contact-type power supply and/or for data exchange with devices external to the data carrier.

2. The data carrier according to claim 1, **characterized in that** the coil (7) is disposed on a cover layer (10) or on an inner layer (11) of the card body (2) or on an injection-molded card body part (12).

3. The data carrier according to claim 2, **characterized in that** the coil (7) is configured as a flat coil which is bonded to an insulating layer of the card body as a finished wire-wound coil, printed on an insulating layer of the card body as an electroconductive layer, or embossed into the card body layer by the hot-stamping method, or punched out of a metal foil or an electroconductively coated plastic foil and disposed on a layer of the card body.

4. The data carrier according to claim 2, **characterized in that** the coil (7) extends substantially over the entire surface of the card body (2).

5. The data carrier according to claim 1, **characterized in that** the terminals (8) of the coil (7) are bonded electroconductively to the contact elements (5) of the module (6).

6. A method for producing a data carrier (1) having a single- or multilayer card body (2), an integrated circuit (4), and at least one coil (7) to be used for power supply and/or for data exchange of the integrated circuit (4) with external devices, wherein
a module (6) is produced which has the integrated circuit (4) and at least two contact elements (5), and
separately from the production of the module (6) the coil (7) is applied to a layer of the card body (2), and said contact elements (5) of the module (6) are positioned such that they are disposed directly opposite the terminals (8) of the coil (7),
**characterized in that** the module (6) additionally has outer contact surfaces (9) for contact-type power supply and/or for data exchange with devices external to the data carrier.

7. The method according to claim 6, **characterized in that** the coil is printed on a card body layer by screen printing by means of an electroconductive adhesive, or the coil is punched out of a metal foil or an electroconductively coated plastic foil and bonded to the card body layer, or the coil is embossed into the card body layer as an electroconductive layer by the hot-stamping method, or applied to the card body layer as a wire-wound coil.

8. The method according to claim 6, **characterized in that** the terminals of the coil are bonded electroconductively to the contact elements of the module.

## Revendications

1. Support de données (1), comportant un corps en forme de carte (2), et composé d'une ou plusieurs couches, d'un circuit intégré (4) ainsi que d'au moins une bobine (7) servant à l'alimentation en énergie et/ou à l'échange de données du circuit intégré (4) avec des appareils extérieurs,
un module (6) comportant le circuit intégré (4) et au moins deux éléments de contact (5) étant, par l'intermédiaire des dits éléments de contact, connecté de manière électroconductrice avec les raccords (8) de la bobine (7) disposée séparément sur une couche du corps de carte,
les raccords (8) de la bobine (7) étant positionnés de telle manière qu'ils sont disposés directement en face des éléments de contact (5) du module (6),
**caractérisé en ce que** le module (6) comporte en outre des surfaces de contact extérieures (9) pour l'alimentation en énergie par contact et/ ou pour l'échange de données avec des appareils extérieurs par rapport au support de données.

2. Support de données selon la revendication 1, **caractérisé en ce que** la bobine (7) est disposée sur une couche de couverture (10) ou sur une couche intérieure (11) du corps de carte (2) ou sur une partie de corps de carte (12) moulée par injection.

3. Support de données selon la revendication 2, **caractérisé en ce que** la bobine (7) est réalisée sous forme de bobine plate qui est collée sous forme de bobine à fil enroulé toute prête sur une couche isolante ou qui est imprimée sous forme de couche électroconductrice sur une couche isolante du corps de carte ou qui est gaufrée dans la couche de corps de carte par procédé de gaufrage à chaud ou qui est découpée dans une feuille de métal ou dans une feuille en matière plastique à revêtement électroconducteur et disposée sur une couche de corps de carte.

4. Support de données selon la revendication 2, **caractérisé en ce que** la bobine (7) s'étend pour l'essentiel sur toute la surface du corps de carte (2).

5. Support de données selon la revendication 1, **caractérisé en ce que** les raccords (8) de la bobine (7) sont collés de manière électroconductrice avec les éléments de contact (5) du module (6).

6. Procédé de fabrication d'un support de données (1) comportant un corps de carte (2) à une ou plusieurs couches, un circuit intégré (4), ainsi qu'au moins une bobine (7) servant à l'alimentation en énergie et/ou à l'échange de données du circuit intégré (4) avec des appareils extérieurs,
un module (6) étant fabriqué, qui comporte le circuit intégré (4) et au moins deux éléments de contact (5), et
la bobine (7) étant appliquée sur une couche du corps de carte (2) séparément de la fabrication du module (6) et les dits éléments de contact (5) du module (6) étant positionnés de telle manière qu'ils sont disposés directement en face des raccords (8) de la bobine (7) du module (6),
**caractérisé en ce que** le module (6) comporte en outre des surfaces de contact extérieures (9) pour l'alimentation en énergie par contact et/ ou pour l'échange de données avec des appareils extérieurs par rapport au support de données.

7. Procédé selon la revendication 6, **caractérisé en ce que** la bobine est imprimée par procédé de sérigraphie sur une couche de corps de carte au moyen d'un adhésif électroconducteur ou **en ce que** la bobine est découpée dans une feuille de métal ou dans une feuille en matière plastique à revêtement électroconducteur et collée sur la couche de corps de carte ou **en ce que** la bobine est gaufrée dans la couche de corps de carte sous forme de couche électroconductrice par procédé de gaufrage à chaud ou appliquée sur la couche de corps de carte sous forme de bobine à fil enroulé.

8. Procédé selon la revendication 6, **caractérisé en ce que** les raccords de la bobine sont sont collés de manière électroconductrice avec les éléments de contact du module.
